# FASCICULE DE BREVET EUROPEEN

(11) **EP 1 465 200 B1**
(45) Date de publication et mention de la délivrance du brevet: **12.11.2008**
(21) Numéro de dépôt: 04290885.5
(22) Date de dépôt: 02.04.2004
(51) Int. Cl.: G11C 11/412, H01L 27/12

(54) **Cellule mémoire statique à accès aléatoire (SRAM), et unité mémoire à ultra basse consommation réalisée à partir de telles cellules**
Statische Direktzugriffspeicherzelle (SRAM) und Speichereinheit die diese enthält mit extrem niedrigem Leistungsverbrauch
Static Random Access Memory cell (SRAM) and ultra-low power memory using the same

(30) Priorité: 02.04.2003 FR 0304127
(43) Date de publication de la demande: 06.10.2004
(73) Titulaire: COMMISSARIAT A L'ENERGIE ATOMIQUE ( CEA), 75015 Paris (FR)
(72) Inventeur: Amara, Amara, 92330 Sceaux (FR); Thomas, Olivier, 38301 Herbeys (FR)
(74) Mandataire: Pontet, Bernard

(56) Documents cités:
- US-A- 5 943 258
- US-A1- 2002 051 379
- US-A1- 2002 109 187
- US-A1- 2002 112 137
- US-B1- 6 442 060
- SUN J Y-C: "CMOS Technology For 1.8V And Beyond" CONFERENCE PROCEEDINGS ARTICLE, 3 juin 1997 (1997-06-03), pages 293-297, XP010241493
- ASSADERAGHI F ET AL: "A dynamic threshold voltage MOSFET (DTMOS) for ultra-low voltage operation" ELECTRON DEVICES MEETING, 1994. TECHNICAL DIGEST., INTERNATIONAL SAN FRANCISCO, CA, USA 11-14 DEC. 1994, NEW YORK, NY, USA,IEEE, 11 décembre 1994 (1994-12-11), pages 809-812, XP010131786 ISBN: 0-7803-2111-1
- NATARAJAN S ET AL: "SOI SRAM design advances & considerations" 9TH IEEE INTERNATIONAL CONFERENCE ON ELECTRONICS, CIRCUITS AND SYSTEMS, vol. 2, 15 septembre 2002 (2002-09-15), pages 835-838, XP010614477
- THOMAS O ET AL: "An SOI 4 transistors self-refresh ultra-low-voltage memory cell" PROCEEDINGS OF THE 2003 IEEE INTERNATIONAL SYMPOSIUM ON CIRCUITS AND SYSTEMS (CAT. NO.03CH37430), ISCAS 2003. INTERNATIONAL SYMPOSIUM ON CIRCUITS AND SYSTEMS, BANGKOK, THAILAND, 25-28 MAY 2003, 25 mai 2003 (2003-05-25), - 28 mai 2003 (2003-05-28) pages V-401-4 vol.5, XP002260222 2003, Piscataway, NJ, USA, IEEE, USA ISBN: 0-7803-7761-3
- LIU S C ET AL: "A novel 0.7 V two-port 6T SRAM memory cell structure with single-bit-line simultaneous read-and-write access (SBLSRWA) capability using partially-depleted SOI CMOS dynamic-threshold technique" SOI CONFERENCE, 1999. PROCEEDINGS. 1999 IEEE INTERNATIONAL ROHNERT PARK, CA, USA 4-7 OCT. 1999, PISCATAWAY, NJ, USA,IEEE, US, 4 octobre 1999 (1999-10-04), pages 75-76, XP010370230 ISBN: 0-7803-5456-7
- TERAUCHI M: "A NOVEL 4T SRAM CELL USING 'SELF-BODY-BIASED' SOI MOSFET STRUCTURE OPERATING AT 0.5 VOLT" 2000 IEEE INTERNATIONAL SOI CONFERENCE PROCEEDINGS. WAKEFIELD, MA, OCT. 2 - 5, 2000, IEEE INTERNATIONAL SOI CONFERENCE, NEW YORK, NY: IEEE, US, 2 octobre 2000 (2000-10-02), pages 108-109, XP001003453 ISBN: 0-7803-6390-6

## Description

La présente invention concerne une cellule mémoire statique à accès aléatoire (SRAM) fonctionnant en ultra basse tension pour une ultra basse consommation. Elle vise également une unité mémoire à ultra basse consommation réalisée à partir de telles cellules.

Le développement considérable des équipements électroniques portables suscite un besoin croissant pour des composants à basse consommation. Cet objectif de basse consommation peut en particulier être atteint en concevant des composants fonctionnant avec une tension d'alimentation ultra basse.

Pour la conception de mémoires SRAM, il est nécessaire d'obtenir un compromis entre des attentes contradictoires telles qu'une bonne stabilité des cellules mémoires assurant une bonne fiabilité (du point de vue du taux d'erreur logiciel (SER : soft Error Rate), de la sensibilité de la mémoire aux tolérances du procédé de fabrication et des conditions de fonctionnement), une taille de cellule la plus faible possible pour une densité maximale, une maximisation du courant de charge pour permettre une vitesse élevée et un courant (statique en mode rétention) de fonctionnement minimal pour assurer une basse consommation d'énergie.

Il existe déjà des cellules mémoires de type 4T-2R. Ces cellules nécessitent un ratio de cellule élevé pour assurer la stabilité et présentent un courant de fuite au repos élevé.

Les cellules mémoire de type 4T-2TFT présentent une compatibilité avec les technologies CMOS et leur résistance modulée permet une amélioration du compromis entre le courant au repos (Ioff) et le courant de charge de la cellule (Ion).

Les cellules mémoires de type 6T PMOS LOAD sont compatibles avec les technologies CMOS et leur structure en « pull-up » actif assure une stabilité de la cellule et une bonne immunité aux erreurs. Ces cellules mémoires présentent un faible courant de fuite au repos. Cependant, l'écriture dans ces cellules est plus difficile que dans des cellules de type 4T-2R/TFT. Par ailleurs, leurs dimensions sont plus grandes que celles des cellules 4T-2R/TFT, d'un facteur 1,5 à 2.

Outre les structures conventionnelles de cellules mémoires, sont maintenant développées des cellules mémoires présentant de nouvelles architectures, telle que l'architecture de cellule à commande de source-ligne proposée par HITACHI et divulguée dans l'article intitulé « Driving Source-Line Cell Architecture for Sub-1V High-Speed Low-Power Applications » paru dans la revue « IEEE Journal Solid-State Circuits » Vol. 31, No. 4, Avril 1996. Cette architecture de cellule, qui est adaptée pour des applications à basse tension et par conséquent basse puissance, requiert de générer des signaux supplémentaires et notamment une source de tension négative. En mode de rétention, SL = Vss, tandis qu'en lecture, SL < 0, et en écriture, SL est flottante.

Il existe aussi une architecture de cellule de type CMOS 4T sans charge proposée par NEC et divulguée dans l'article intitulé « A 16-Mb 400-MHz loadless CMOS Four-Transistor SRAM Macro » paru dans la revue « IEEE Journal of Solid-State Circuits » Vol.35, No11, Novembre 2000. Cette cellule a en pratique la taille d'une cellule de type 4T-2R. Elle est toutefois sensible au désappariement de la technologie et à la température. Par ailleurs, elle nécessite des circuits supplémentaires pour procurer la fonction de rafraîchissement de cellule et sa fiabilité.

Il existe également deux architectures de cellule de type CMOS 4T sans transistors de conduction brevetés par Texas Instrument (TI) et Monolithic System Technology (Mosys) en 2002, intitulés respectivement « Loadless 4T SRAM cell with PMOS drivers » et « High-density ratio-independent four-transistor RAM cell fabricated with conventional logic process » et de référence respective NO. US 2002/0051379 A1 et NO. US 6,442,060 B1. Les architectures proposées dans ces deux brevets ont été développées en technologie CMOS BULK. Par rapport à l'architecture NEC ces dernières présentent l'avantage d'une meilleure stabilité en température due au courant de grille des transistors de type PMOS dix fois moins importants que ceux des transistors NMOS. Par contre, la cellule TI présente l'inconvénient, en mode lecture, d'activer les transistors d'accès avec une tension sur la ligne de mot égale à 90 % de la tension d'alimentation du dispositif pour garantir une bonne stabilité de la cellule mémoire dans cet état. Cette contrainte limite le courant de conduction sortant de la cellule lors d'un cycle de lecture et affecte les performances du système. De plus, comme pour la cellule NEC, l'architecture TI est sensible au désappariement de la technologie. En ce qui concerne l'architecture Mosys, elle présente également l'intérêt d'avoir un très fort taux d'intégration dû au dimensionnement minimal des transistors de la cellule. La contre partie concerne le besoin d'une alimentation du substrat des transistors de charge PMOS plus élevée que la tension d'alimentation du dispositif pour augmenter leur tension de seuil et réduire leurs courants de fuite.

La cellule mémoire statique de l'invention est définie par la revendication 1.

Le but de la présente invention est de proposer une topologie de cellule mémoire à ultra basse consommation, qui permette de remédier aux inconvénients précités.

Cet objectif est atteint avec une cellule mémoire statique à accès aléatoire (SRAM), comprenant :
- un premier et un second transistors de charge, de technologie MOSFET, agencés pour contrôler et maintenir les potentiels respectifs d'un premier et d'un second noeuds de stockage par rapport à une référence de tension et,
- un premier et un second transistors d'accès, de technologie MOSFET complémentaire de celle desdits transistors de charge, disposés respectivement (i) entre une ligne de bit et le premier noeud de stockage et (ii) entre une ligne de bit complémentaire et le second noeud de stockage, et ayant leurs grilles respectives reliées à une ligne de mot.

Suivant l'invention, les transistors de charge et d'accès sont réalisés en technologie Silicium sur Isolant (SOI) .

Dans cette nouvelle architecture d'une cellule mémoire à quatre transistors implémentée en technologie SOI, les transistors de charge ont pour fonction d'assurer et de maintenir la charge nécessaire à l'établissement d'un niveau logique '1', correspondant au potentiel égal à la tension d'alimentation, à l'un ou l'autre des noeuds en fonction de la valeur logique mémorisée.

Les deux transistors d'accès, dont les substrats sont laissés flottants, ont pour fonction d'autoriser, lors d'un cycle de lecture ou d'écriture, l'accès aux potentiels des noeuds. Par ailleurs, ces transistors d'accès contribuent à maintenir le niveau logique '0' aux noeuds en fonction de la valeur logique mémorisée. Le maintien du niveau logique '0' est effectué par un système d'autorégulation des charges du noeud.

Dans une forme de réalisation particulièrement avantageuse, les transistors de charge sont de type PMOS et ont leurs sources respectives reliées à une source de tension d'alimentation, tandis que les transistors d'accès sont de type NMOS et ont leurs drains respectifs reliés respectivement aux premier et second noeuds de stockage.

Dans un mode particulier d'implémentation, les premier et second transistors de charge (T_{L1}, T_{L2}) ont leurs drains respectifs définissant respectivement lesdits premier et second noeuds de stockage et reliés respectivement aux grilles respectives du second transistor de charge et du premier transistor de charge, et les premier et second transistors d'accès (T_{A1}, T_{A2}) ont leurs sources respectives reliées respectivement à la ligne de bit (BLT) et à la ligne de bit complémentaire (BLC).

Les premier et second transistors de charge sont de préférence montés selon la technologie DTMOS (Dynamic Threshold Métal Oxide Semiconductor : *Métal Oxyde Semiconducteur* à *seuil dynamique).*

Les charges électriques, à l'un ou l'autre des noeuds de stockage (A, B) selon l'état de la ligne de bit (BLT), sont autorégulées de sorte que le potentiel dudit noeud est maintenu au niveau logique '0'.

Dans une forme particulière de réalisation d'une cellule mémoire selon l'invention, les transistors de charge (T_{L1}, T_{L2}) opèrent comme des transistors de conduction de type PMOS montés en DTMOS et les transistors d'accès (T_{A1}, T_{A2}) sont de type NMOS et à substrat flottant.

La ligne de bit (BLT) et la ligne de bit complémentaire (BLC) sont alors préchargées à la tension d'alimentation (V_{SS}),et la ligne de mot (WL) est prévue pour commander les transistors d'accès (T_{A1}, T_{A2}), soit en blocage à 0 volt, soit en activation à la tension d'alimentation (V_{DD}).

Grâce à la nouvelle architecture des cellules mémoires selon l'invention, et aux caractéristiques électriques des transistors SOI, en mode de rétention, les valeurs logiques mémorisées n'ont pas besoin d'être rafraîchies par des circuits électriques externes et complémentaires, contrairement aux cellules mémoires du type « Loadless CMOS 4T ».

De plus, une cellule mémoire selon l'invention permet une précharge des lignes de bit à 0 et ne requiert pas une forte différence de potentiels entre ces lignes de bit lors d'une opération d'écriture ou de lecture, ce qui contribue à minimiser la consommation électrique des lignes de bits de la cellule mémoire.

En outre, du fait de la structure des transistors SOI et de l'architecture à quatre transistors de la cellule mémoire selon l'invention, il est possible de réaliser un plan mémoire à forte capacité d'intégration.

Ainsi, la présente invention procure à la fois une très bonne stabilité, une très faible consommation et un taux d'intégration élevé. La cellule mémoire selon l'invention est agencée pour fonctionner en ultra basse tension, i.e. égale ou inférieure à la tension de conduction d'une jonction PN (0.7 V et en dessous). Par ailleurs, le rapport de la largeur d'un transistor d'accès sur la largeur du transistor de charge relié au transistor d'accès est de préférence égal ou supérieur à 1.5 suivant la technologie utilisée.

Suivant un autre aspect de l'invention, il est proposé une unité mémoire comprenant un tableau de cellules mémoires statiques à accès aléatoire (SRAM), des moyens de registre d'entrée de données, des moyens de registre de sortie de données, des moyens de registre d'adresse, et des moyens d'écriture/lecture, lesdites cellules mémoires comprenant :
- un premier et un second transistors de charge, de technologie MOSFET, agencés pour contrôler et maintenir les potentiels respectifs d'un premier et d'un second noeuds de stockage par rapport à une référence de tension et,
- un premier et un second transistors d'accès, de technologie MOSFET complémentaire de celle desdits transistors de charge, disposés respectivement (i) entre une ligne de bit et le premier noeud de stockage et (ii) entre une ligne de bit complémentaire et le second noeud de stockage, et ayant leurs grilles respectives reliées à une ligne de mot.

Cette unité mémoire est caractérisée en ce que les transistors de charge et d'accès sont réalisés en technologie Silicium sur Isolant (SOI), ces transistors de charge étant de type PMOS et ayant leurs sources respectives reliées à une source de tension d'alimentation, et lesdits transistors d'accès étant de type NMOS et ayant leurs drains respectifs reliés respectivement auxdits premier et second noeuds de stockage.

Les moyens de lecture de chaque cellule mémoire peuvent être agencés pour opérer soit en tension, soit en courant.

D'autres avantages et caractéristiques de l'invention apparaîtront à l'examen de la description détaillée d'un mode de mise en oeuvre nullement limitatif, et des dessins annexés sur lesquels :
- la figure 1 est un schéma synoptique d'une unité mémoire selon l'invention ;
- la figure 2a est une coupe transversale d'un transistor SOI à substrat flottant, mis en oeuvre comme transistor d'accès dans une cellule mémoire selon l'invention ;
- la figure 2b est une coupe transversale d'un transistor SOI monté en DTMOS, mis en oeuvre comme transistor de charge dans une cellule mémoire selon l'invention ;
- la figure 3 est un schéma fonctionnel d'une cellule mémoire selon l'invention ;
- la figure 4 illustre l'évolution de la différence de potentiel entre les noeuds A et B dans une cellule mémoire selon l'invention en fonction du rapport dimensionnel de cette cellule ;
- la figure 5a illustre l'évolution temporelle des potentiels respectifs des noeuds A et B, illustrant le phénomène d'autorégulation du potentiel de niveau logique « 0 » ;
- la figure 5b illustre l'évolution temporelle des tensions respectives V_{body-source} des transistors d'accès lors d'un cycle d'écriture dans une cellule mémoire selon l'invention ;
- la figure 6a illustre l'évolution temporelle d'un signal de commande sur la ligne de mot WL, qui est appliqué lors d'un cycle d'écriture dans une cellule mémoire selon l'invention ;
- la figure 6b illustre l'évolution temporelle de signaux de commande appliqués respectivement sur la ligne de bit et sur la ligne de bit complémentaire, lors d'un cycle d'écriture dans une cellule mémoire selon l'invention ;
- la figure 6c illustre l'évolution temporelle des potentiels respectifs de la ligne de bit et de la ligne de bit complémentaire, lors d'un cycle d'écriture dans une cellule mémoire selon l'invention ;
- la figure 6d illustre l'évolution temporelle des potentiels respectifs des noeuds A et B d'une cellule mémoire selon l'invention, lors d'un cycle d'écriture ; et
- la figure 6e illustre l'évolution temporelle des tensions V_{substrat-source} des transistors d'accès lors d'un cycle d'écriture dans une cellule mémoire selon l'invention.

On va maintenant décrire, en référence aux figures précitées, la structure d'une cellule mémoire selon l'invention et d'une unité mémoire incluant de telles cellules mémoires, ainsi que le fonctionnement de cette cellule mémoire dans les différents modes de lecture, d'écriture et de rétention.

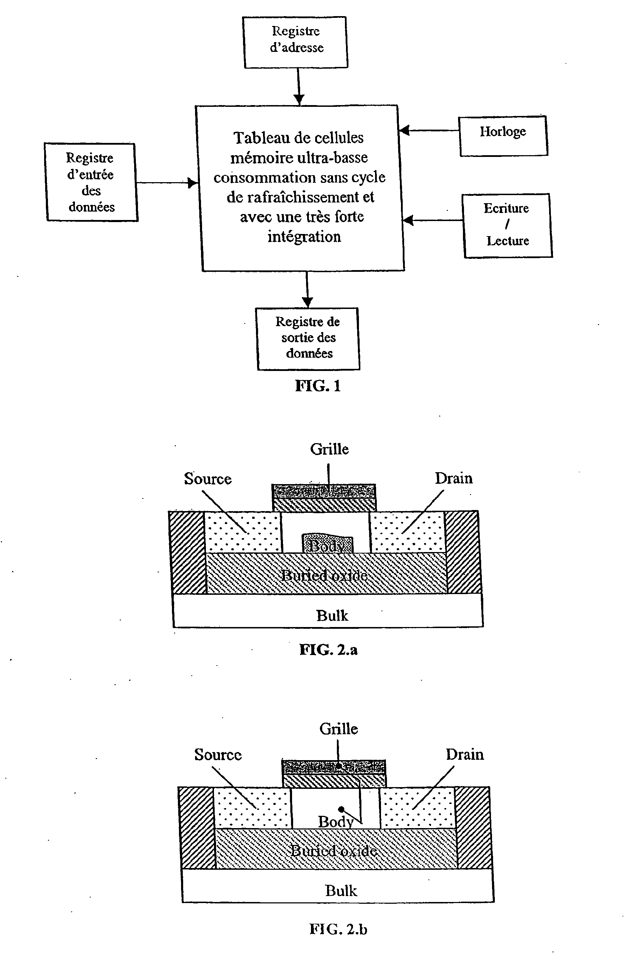

Une unité mémoire selon l'invention comprend, en référence à la figure 1, un tableau de cellules mémoires à ultra basse consommation selon l'invention, auquel sont associés un registre d'adresse, un registre d'entrée des données, une horloge, une circuiterie d'écriture/lecture, et un registre de sortie de données. Les cellules mémoires du tableau, qui ne requièrent pas de cycle de rafraîchissement et présentent une très forte intégration, sont arrangées sous la forme d'une matrice conventionnelle.

Le registre d'adresse est prévu pour adresser ou sélectionner une cellule de la matrice. Sa fonction est de décoder les coordonnées, c'est-à-dire la ligne et la colonne, de chaque cellule à partir d'un mot d'adresse de plusieurs bits. Le registre d'entrée de données a pour fonction de fournir les bits d'un mot qui doivent être mémorisés dans le tableau lors d'une opération d'écriture.

Le registre de sortie de données a pour fonction de recevoir les bits du mot mémorisé à l'adresse définie dans le registre d'adresse lors d'une opération de lecture.

Les transistors d'accès prévus dans une cellule mémoire selon l'invention présentent, en référence à la figure 2a, une structure de transistor NMOS/SOI à substrat flottant, tandis que les transistors de charge présentent, en référence à la figure 2b, une structure de transistor PMOS/SOI monté en DTMOS.

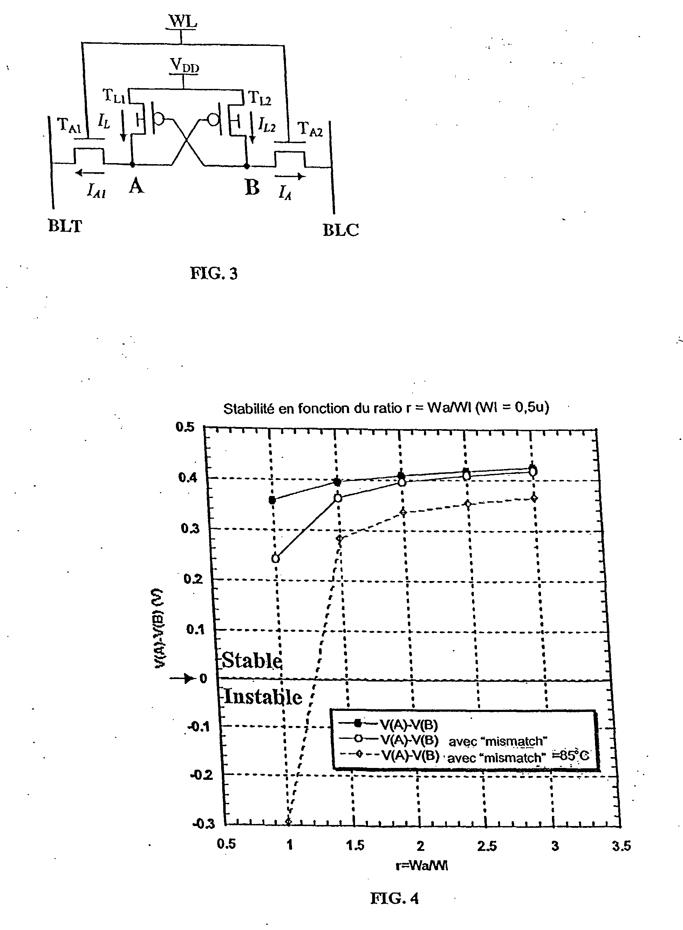

Chaque cellule mémoire comporte, au schéma de la figure 3, deux transistors de charge T_{L1}, T_{L2} de type PMOS/SOI montés en DTMOS, qui ont pour fonction d'assurer et de maintenir la charge nécessaire à l'établissement d'un niveau logique '1' correspondant à un potentiel égal à la tension d'alimentation V_{dd}. Les sources respectives de ces deux transistors de charge sont reliées à une ligne maintenue à cette tension d'alimentation V_{dd}, tandis que leurs drains respectifs sont reliés aux grilles respectives des transistors opposés et représentent les deux noeuds de stockage A, B.

Chaque cellule mémoire comporte en outre deux transistors d'accès T_{A1}, T_{A2} qui ont pour fonction d'autoriser, lors d'un cycle de lecture ou d'écriture, l'accès aux potentiels des noeuds A et B. Par ailleurs, ces deux transistors d'accès contribuent, en mode de rétention, à maintenir le niveau logique '0' aux noeuds A ou B en fonction de la valeur logique mémorisée. Le maintien du niveau logique '0' est obtenu par un mécanisme d'autorégulation des charges du noeud qui sera expliqué dans la suite.

Les drains respectifs des deux transistors d'accès T_{A1}, T_{A2} sont reliés, aux noeuds A et B, aux drains respectifs des deux transistors de charge, tandis que leurs sources respectives sont reliées respectivement à une ligne de bit BLT et à une ligne de bit complémentaire BLC. Les grilles respectives des deux transistors d'accès T_{A1}, T_{A2} sont reliées à une ligne de mot WL.

On va maintenant décrire, en référence aux figures 4 à 6e, les différents modes opérationnels mis en oeuvre dans une cellule mémoire selon l'invention.

En mode de rétention, la nouvelle topologie de cellule mémoire selon l'invention procure l'avantage de ne pas nécessiter de cycle de rafraîchissement et d'assurer, grâce à une forte rétroaction entre les deux transistors de charge T_{L1}, T_{L2} , de bons niveaux logiques. Dans ce mode, la ligne de mot WL et les lignes de bit BLT, BLC sont polarisées et maintenues à un potentiel nul. Les transistors d'accès T_{A1}, T_{A2} présentent alors des tensions V_{Grille-Source} égales à 0V, ce qui les conditionne dans un état bloqué. Les courants Drain-Source, issus de ces transistors, sont des courants de fuite proportionnels aux tensions V_{Body-Source} et V_{Drain-Source} de chacun d'entre eux.

Pour un niveau logique mémorisé '1', correspondant à A='1' et B='0', le transistor T_{L2} est également dans un état bloqué (V_{Grille-Source}=0). Comme ce transistor est monté en DTMOS, le courant de fuite qui le traverse est minimisé par sa tension V_{Body-Source} nulle.

Pour maintenir le potentiel du noeud B proche de 0V, il est nécessaire que le transistor d'accès T_{A2} conduise le courant issu du transistor de charge T_{L2} dans la ligne de bit complémentaire BLC. Pour une largeur de grille fixe, le courant de fuite conduit par le transistor d'accès T_{A2} est fonction du potentiel de son substrat flottant (body). Si le potentiel V(B) au noeud B augmente, le potentiel du substrat flottant du transistor d'accès T_{A2} augmente aussi par des effets physiques propres à la technologie SOI et par un couplage capacitif C_{Drain-Body} qui existe entre le drain et le substrat flottant du transistor. Ceci entraîne une augmentation exponentielle du courant dans le transistor d'accès T_{A2} qui devient rapidement plus grand que le courant fourni par le transistor de charge T_{L2}, ce qui limite ainsi la charge du noeud B. En même temps, la diminution de la tension V_{Drain-Source} du transistor de charge T_{L2} et l'augmentation de la tension V_{Drain-Source} du transistor d'accès T_{A2} viennent renforcer cette évolution (diminution et augmentation linéaire du courant suivant VDS).

La minimisation du potentiel au noeud B implique un dimensionnement approprié des transistors de la cellule mémoire. En effet, l'amplitude du potentiel au noeud B est proportionnelle au ratio r=W_{A}/W_{L} de la largeur W_{A} du transistor d'accès sur la largeur W_{L} du transistor de charge, dans le cas présent le transistor d'accès T_{A2} et le transistor de charge T_{L2}.

En référence à la figure 4 qui représente la stabilité d'une cellule mémoire selon l'invention par la variation de la différence de tension (V(A)-V(B)) entre le noeud A et le noeud B en fonction du ratio r, il apparaît que la cellule mémoire est stable tant que la différence de tension est positive. L'étude de stabilité d'une cellule mémoire selon l'invention a été effectuée en fonctionnement standard ou typique et dans des situations limites, notamment en présence de bruit de procédé (en anglais : mismatch) entre les transistors et en présence de température. A titre d'exemple non limitatif, pour une technologie SOI à 0.25µm, on observe que la cellule mémoire reste stable pour r=1.5 et au dessus. On peut envisager une diminution de ce ratio pour d'autres technologies.

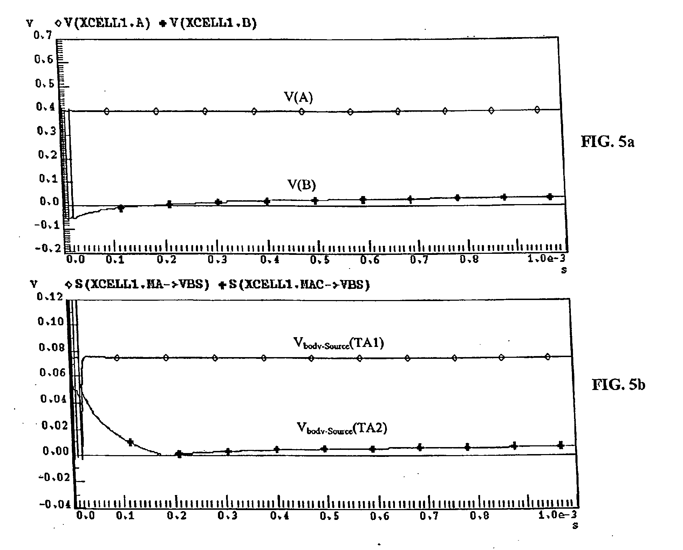

Comme l'illustrent les figures 5a et 5b, le potentiel V(B) au noeud B d'une cellule mémoire selon l'invention tend vers une valeur de potentiel constante et de faible amplitude, selon un processus d'autorégulation du potentiel du noeud B.

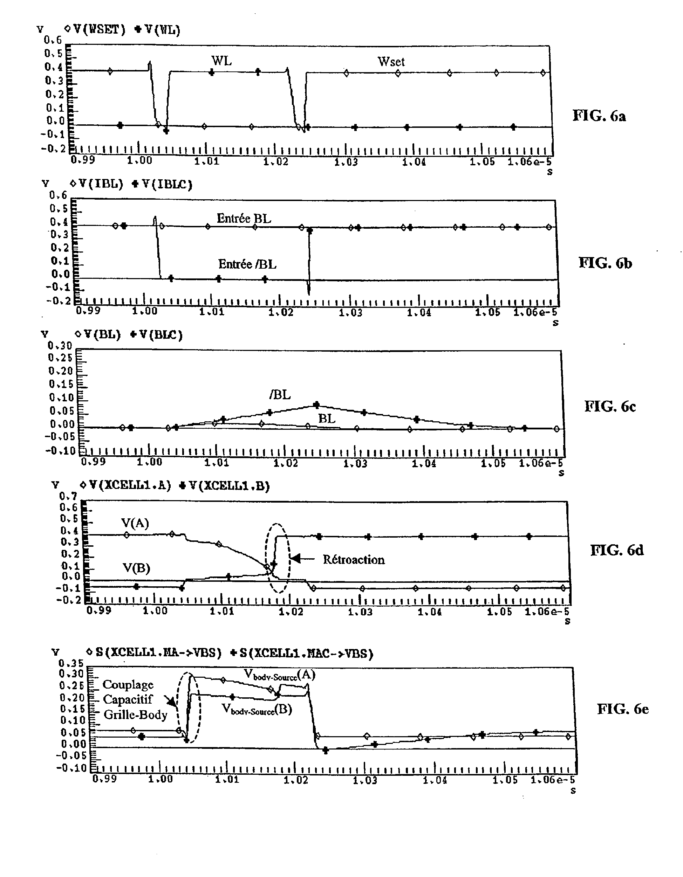

En mode d'écriture, la charge dynamique du substrat flottant des transistors d'accès T_{A1}, T_{A2}, via un couplage capacitif Grille-Body lors de la commutation du signal WL sur la ligne de mot (figure 6a), ainsi qu'une très forte rétroaction des transistors de charge T_{L1}, T_{L2} montés en DTMOS, contribuent à accroître la vitesse d'écriture des cellules mémoires selon l'invention qui est intrinsèquement modérée du fait d'une tension d'alimentation faible (de l'ordre du demi volt et en dessous). Il est à noter que la tension maximale de fonctionnement n'est limitée que par la tension de conduction d'une jonction PN, en général 0.6V.

En mode d'écriture, les lignes de bit BLT et BLC sont chargées de façon complémentaire. Si l'on souhaite écrire un '0' logique au noeud B et un '1' logique au noeud A, la ligne de bit BLT et la ligne de bit complémentaire BLC sont chargées respectivement à un potentiel correspondant au niveau logique haut et à un potentiel nul qui tend vers la moitié de la tension d'alimentation V_{dd}. La ligne de mot WL est activée et désactivée quelques nanosecondes après et avant que les lignes de bit ne soient elles-mêmes activées et désactivées.

Les figures 6a à 6e illustrent un cycle d'écriture et met en avant la charge dynamique des substrats flottants des transistors d'accès (figure 6e) ainsi que le phénomène de rétroaction des transistors de charge (figure 6d). La très bonne rétroaction de la structure de cellule mémoire selon l'invention est due à un très bon rapport Iₒₙ (courant passant) /I_{off} (courant de fuite en mode bloqué) des transistors de charge T_{L1}, T_{L2} montés en DTMOS.

Le mode de lecture d'une cellule mémoire selon l'invention peut être réalisé soit en tension, soit en courant. Comme dans le mode d'écriture, lors de l'activation du signal de ligne de mot WL, le couplage capacitif Grille-Body des transistors d'accès contribue à charger dynamiquement leur substrat et doper leur capacité à conduire du courant. Grâce au très bon rapport Iₒₙ/I_{off} des transistors de charge T_{L1}, T_{L2}, le rapport du courant I_{Drain-Source} du premier transistor d'accès T_{A1} sur le courant I_{Drain-Source} du second transistor d'accès T_{A2} est aussi très élevé, ce qui procure un grand avantage pour une lecture en courant.

Bien sûr, l'invention n'est pas limitée aux exemples qui viennent d'être décrits et de nombreux aménagements peuvent être apportés à ces exemples sans sortir du cadre de l'invention.

## Revendications

1. Cellule mémoire statique à accès aléatoire ditee SRAM, comprenant :
- un premier et un second transistors de charge (T_{L1}, T_{L2}), de technologie MOSFET, agencés pour contrôler et maintenir les potentiels respectifs d'un premier et d'un second noeuds de stockage (A, B) par rapport à une référence de tension et,
- un premier et un second transistors d'accès (T_{A1}, T_{A2}), de technologie MOSFET complémentaire de celle desdits transistors de charge, disposés respectivement (i) entre une ligne de bit (BLT) et ledit premier noeud de stockage (A) et (ii) entre une ligne de bit complémentaire (BLC) et ledit second noeud de stockage (B), et ayant leurs grilles respectives reliées à une ligne de mot (WL),
- les premier et second transistors de charge (T_{L1}, T_{L2}) ont leurs drains respectifs définissant respectivement lesdits premier et second noeuds de stockage et reliés respectivement aux grilles respectives dudit second transistor de charge et dudit premier transistor de charge, et en ce que les.premier et second transistors d'accès (T_{A1}, T_{A2}) ont leurs sources respectives reliées respectivement à la ligne de bit (BLT) et à la ligne de bit complémentaire (BLC),
- les transistors de charge (T_{L1}, T_{L2}) sont de type PMOS et ont leurs sources respectives reliées à une source de tension d'alimentation (V_{DD}), et en ce que les transistors d'accès (T_{A1}, T_{A2}) sont de type NMOS et ont leurs drains respectifs reliés respectivement auxdits premier et second noeuds de stockage (A, B),
**caractérisée en ce que :**
- les dits transistors de charge et les dits transistors d'accès sont réalisés en technologie Silicium sur Isolant dite SOI,
- les premier et second transistors de charge (T_{L1}, T_{L2}) sont montés selon la configuration DTMOS, ditee Dynamic Threshold Metal Oxide Semiconductor ou Métal Oxyde Semiconducteur à seuil dynamique et,
- les premier et second transistors d'accès (T_{A1}, T_{A2}) sont du type à substrat flottant.

2. Cellule mémoire selon la revendication 1, **caractérisée en ce que** la ligne de bit (BLT) et la ligne de bit complémentaire (BLC) sont préchargées à 0 V, et **en ce que** la ligne de mot (WL) est prévue pour commander les transistors d'accès (T_{A1}, T_{A2}).

3. Cellule mémoire selon les revendications 1 et 2, **caractérisée en ce que** la source de tension d'alimentation (V_{DD}) est égale ou inférieure à la tension de conduction des jonctions PN des transistors de la technologie utilisée.

4. Unité mémoire comprenant un tableau de cellules mémoires statiques à accès aléatoire ditee SRAM selon la revendication 1, **caractérisée en ce qu'**elle comprend en outre des moyens de registre d'entrée de données, des moyens de registre de sortie de données, des moyens de registre d'adresse, et des moyens d'écriture/lecture.

## Claims

1. Static random access memory cell said SRAM including:
- a first and a second charge transistors (T_{L1}, T_{L2}), of MOSFET technology, arranged to control and maintain respective potentials of a first and a second stock node (A, B) regarding to a voltage reference and,
- a first and a second access transistors (T_{A1}, T_{A2}), of MOSFET technology complementary of that one of said charge transistors, respectively arranged (i) between one bit line (BLT) and said first stock node (A) and (II) between one complementary bit line (BLC) and said second stock node (B), and with their respective gates connected to a words line (WL),
- the first and second charge transistors (T_{L1}, T_{L2}) have their respective drains defining respectively said first and second stock nodes and connected respectively to the respective gates of said second charge transistor and of said first charge transistor, and the first and second access transistors (T_{A1}, T_{A2}) have their respective sources connected respectively to the bit line (BLT) and to the complementary bit line (BLC),
- the charge transistors (T_{L1}, T_{L2}) are PMOS type and have their respective sources connected to a supply voltage source (V_{DD}), and access transistors (T_{A1}, T_{A2}) are NMOS type and have their respective drains connected respectively to said first and second stock nodes (A, B),
**characterized in**:
- the said charge transistors and said access transistors are realized in Silicium On Insulator technology said SOI,
- the first and second charge transistors (T_{L1}, T_{L2}) are assembled according to the DTMOS configuration, said Dynamic Threshold Metal Oxide Semiconductor and,
- the first and second access transistor (T_{A1}, T_{A2}) are floating substrate type.

2. Memory cell according to claim 1, **characterized in that** the bit line (BLT) and the complementary bit line (BLC) are precharged at 0 V*ᵣ* and **in that** the word line (WL) is foreseen to command the access transistors (T_{A1}, T_{A2}).

3. Memory cell according to claims 1 and 2, **characterized in that** the supply voltage source (V_{DD}) is equal or inferior to the conduction voltage of the PN junctions of the transistors of the technology used.

4. Memory unit including a board of static random access memory cells said SRAM according claim 1, **characterized in that** It includes also register of data export media, address register media, and writing/reading media.

## Patentansprüche

1. SRAM genannte statische Direktzugriffspeicherzelle, umfassend:
- einen ersten und einen zweiten Ladungstransistor (T_{L1}, T_{L2}) der MOSFET-Technologie, die angeordnet sind, um die jeweiligen Potentiale eines ersten und eines zweiten Spelcherknotenpunkts (A, B) Im Verhältnis zu einer Spannungsreferenz zu steuern und halten, und
- einen ersten und einen zweiten Zugriffstransistor (T_{A1}, T_{A2}), die In einer MOSFET-Technologle, die zu der der besagten Ladungstransistoren ergänzend ist, und die jeweils (i) zwischen einer Bitleitung (BLT) und dem besagten ersten Speicherknotenpunkt (A), und (ii) zwischen einer ergänzenden Bitleitung (BLC) und dem besagten zweiten Speicherknotenpunkt (B) angeordnet sind, wobei die Gates dieser Zugriffstransistoren jeweils mit einer Wortleitung (WL) verbunden sind,
- wobei die jeweilige Drain-Anschlüsse des ersten und des zweiten Ladungstransistors (T_{L1}, T_{L2}) jeweils den besagten ersten und zweiten Speicherknotenpunkt definieren und jeweils mit den jeweiligen Gates des besagten zweiten Ladungstransistors und des besagten ersten Ladungstransistors verbunden sind, und die jeweilige Source-Anschlüsse des ersten und des zweiten Zugriffstransistors (T_{A1}, T_{A2}), jeweils mit der Bitleitung (BLT) und der ergänzenden Bitleitung (BLC) verbunden sind,
- wobei die Ladungstransistoren (T_{L1}, T_{L2}) vom PMOS-Typ sind und ihre jeweiligen Source-Anschlüsse mit einer Versorgungsspannungsquelle (V_{DD}) verbunden sind, und dabei die Zugriffstransistoren (T_{A1}, T_{A2}) vom NMOS-Typ sind und ihre jeweiligen Drain-Anschlüsse jeweils mit dem besagten ersten und zweiten Speicherknotenpunkt (A, B) verbunden sind,
**dadurch gekennzeichnet, dass:**
- die besagten Ladungstransistoren und die besagten Zugriffstransistoren in SOI genannte Silizium-auf-Isolator Technologie ausgebildet sind,
- der erste und der zweite Ladungstransistor (T_{L1}, T_{L2}) gemäß der DTMOS-Konfiguration montiert werden, die Dynamic Threshold Metal Oxide Semiconductor oder Metaloxidhalbleiter mit dynamischer Schwelle genannt ist, und,
- der erste und der zweite Zugriffstransistor (T_{A1}, T_{A2}) vom mit Schwimmsubstrat sind.

2. Spelcherzelle gemäß Anspruch 1, **dadurch gekennzeichnet, dass** die Bitleitung (BLT) und die ergänzende Bitleitung (BLC) auf 0 V vorgeladen werden, und dass die Wortleitung (WL) dazu vorgesehen ist, die Zugriffstransistoren (T_{A1}, T_{A2}) zu steuern.

3. Speicherzelle gemäß den Ansprüchen 1 und 2, **dadurch gekennzeichnet, dass** die Versorgungsspannungsquelle (V_{DD}) gleich oder kleiner als die Leitungsspannung der PN-Übergänge der Transistoren der verwendeten Technologie ist.

4. Speicherzelle, die ein Array von SRAM genannten statischen Direktzugriffspeicherzellen gemäß Anspruch 1 umfasst, **dadurch gekennzeichnet, dass** sle außerdem Registermittel für den Dateneingang, Registermittel für den Datenausgang, Registermittel für die Adresse und Schreib- /Lesemittel umfasst.
